(19) Europäisches Patentamt
European Patent Office
Office européen des brevets

(11) Veröffentlichungsnummer: **0 489 195 A1**

(12) **EUROPÄISCHE PATENTANMELDUNG**

(21) Anmeldenummer: **90123359.3**

(22) Anmeldetag: **05.12.90**

(51) Int. Cl.5: **H03H 9/70**, H03H 9/145

(43) Veröffentlichungstag der Anmeldung:
**10.06.92 Patentblatt 92/24**

(84) Benannte Vertragsstaaten:
**AT BE CH DE DK ES FR GB GR IT LI LU NL SE**

(71) Anmelder: **SIEMENS MATSUSHITA COMPONENTS GmbH & CO KG**
**Balanstrasse 73**
**W-8000 München 80(DE)**

(72) Erfinder: **Ehrmann-Falkenau, Ekkehard, Dr.-Ing.**
**verstorben**
**/(DE)**
Erfinder: **Zibis, Peter, Dipl.-Ing.**
**Niemöller Allee 19**
**W-8000 München 83(DE)**

(74) Vertreter: **Fuchs, Franz-Josef, Dr.-Ing. et al**
**Postfach 22 13 17**
**W-8000 München 22(DE)**

(54) **Fernseh-ZF-Filter für Ouasi-/Paralleltonanwendungen.**

(57) Fernseh-ZF-Filter für Quasi-/Paralleltonanwendungen, mit einem Eingangswandler (EWI) für das ZF-Videosignal und einem hierzu parallelgeschalteten Eingangswandler für das Ton- und Bildträgersignal, wobei dieser in zueinander parallelgeschaltete Eingangswandler (EWIV; EWV) für das Ton- bzw. Bildträgersignal (b, c) mit einem gemeinsamen Ausgangswandler (AWIV-V) aufgetrennt ist, dessen Apertur die Aperturen der Eingangswandler (EWIV, EWV) für das Ton- bzw. Bildträgersignal umfaßt.

FIG 5

Die Erfindung betrifft ein Fernseh-ZF-Filter für Quasi-/Paralleltonanwendungen, mit einem Eingangswandler für das ZF-Viedeosignal und einem hierzu parallelgeschalteten Eingangswandler für das Ton- und Bildträgersignal.

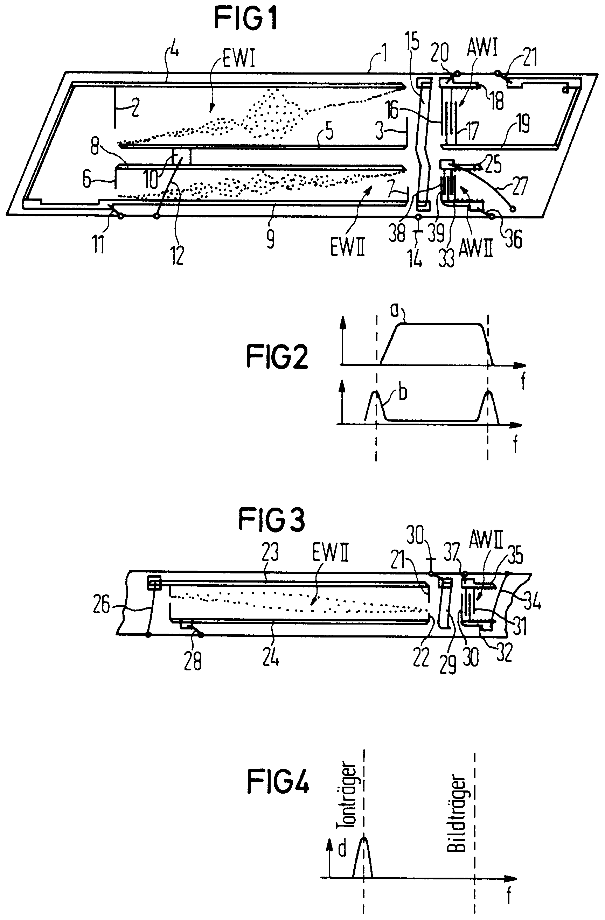

Fernsehfilter der vorstehend genannten Art bestehen aus einem Eingangswandler, Multistripkoppler und zwei Ausgangswandlern oder aus einem Eingangswandler mit großer Apertur und zwei Ausgangswandlern kleinerer Apertur oder - wie dies in Figur 1 schematisch dargestellt ist und in der Detailbeschreibung näher erläutert wird, aus zwei parallelgeschalteten Eingangswandlern EWI und EWII und zwei Ausgangswandlern AWI und AWII.

Diese Ausführungsform eines Filters hat den Vorteil geringerer Filterdämpfung, jedoch den Nachteil, daß Signale des Eingangswandlers EWII für das Ton- und Bildträgersignal in den Ausgangswandler AWI für das ZF-Videosignal übersprechen und dadurch die Nachbarkanalunterdrückung im Bildkanal erheblich beeinträchtigen. Im Unterschied hierzu stört dabei das Übersprechen vom Bild- auf den Tonkanal nicht.

Da bei dieser Ausführungsform eine genaue, alle Phasenverhältnisse exakt wiedergebende Berechnung des Filters nicht möglich ist, muß durch Variation der Wandlerabstände die günstigste Lage der Wandler zueinander experimentell und damit mit erheblichem Aufwand ermittelt werden.

Der in Figur 1 gezeigte herkömmliche Eingangswandler EWII für das Ton- und Bildträgersignal weist eine Wandlerstruktur, d.h. insbes.Überlappungsstruktur seiner Elektrodenfinger auf, welche mehrere Hauptkeulen und damit Bereiche großer Überlappung und zahlreiche Nebenkeulen, d. h. Bereiche mit geringer Überlappung der Elektrodenfinger bildet.

Im Unterschied hierzu besitzt ein z.B. in Figur 3 dargestelltes und gleichfalls in der Detailbeschreibung näher erläutertes Filter mit einem nur für die Übertragung des Tonsignals bestimmten Eingangswandlers EWIII eine Wandlerstruktur, d.h. Überlappungsstruktur seiner Elektrodenfinger mit nur einer breiten Hauptkeule und nur wenige kleine Überlappungen der restlichen Elektrodenfinger unterschiedlicher Polarität.

Der vorliegenden Erfindung liegt die Aufgabe zugrunde, ein Fernseh-ZF-Filter der eingangs genannten Art zu schaffen, das die erwähnten Nachteile, z.B. bei der Ausführungsform nach Figur 1 das Übersprechen der Signale des Eingangswandlers für das Ton- und Bildträgersignal in den Ausgangswandler für das Videosignal unterbindet und Experimente hinsichtlich der Variation von Wandlerabständen hinfällig macht.

Zur Lösung dieser Aufgabe sieht die Erfindung bei einem Fernseh-ZF-Filter gemäß Oberbegriff des Patentanspruchs vor, daß der Eingangswandler für das Ton- und Bildträgersignal in zueinander parallelgeschaltete Eingangswandler für das Ton- bzw. Bildträgersignal mit einem gemeinsamen Ausgangswandler aufgetrennt ist, dessen Apertur die Aperturen der Eingangswandler für das Ton- bzw. Bildträgersignal umfaßt.

Die Erfindung wird nachstehend anhand der Zeichnung näher erläutert. Es zeigt:

Figur 1

eine Ausführungsform eines bekannten Fernseh-ZF-Filters in schematischer Darstellung und Draufsicht,

Figur 3

in der Darstellung nach Figur 1 ein Ausführungsbeispiel eines bekannten Filters mit einem Eingangswandler mit nur einem Tonträgersignal für die Toninformation,

Figur 5

gleichfalls in der Darstellung nach Figur 1 ein Fernseh-ZF-Filter nach der Erfindung,

Figur 2, 4 und 6

je Filter - siehe Figur 1, 3 und 5 - die Übertragungscharakteristik für das Video-, Bild- und Tonträgersignal.

Das Filter gemäß Figur 1 besitzt ein einkristallines, piezoelektrisches Substrat 1, z.B. aus Lithiumniobat oder Lithiumtantalat. Dessen eine Substratseite trägt einen Eingangswandler EWI für das ZF-Videosignal - siehe Figur 2, Kurve a -, einen über den Kontakt 10 parallelgeschalteten gemeinsamen Eingangswandler EWII für das Ton- und Bildträgersignal - siehe Figur 2, Kurve b - eine bei 14 geerdete Abschirmelektrode 15 und getrennte Ausgangswandler AWI und AWII.

Die Elektrodenfinger 2, 3; 6, 7; 16, 17; 38, 39; der Ein- und Ausgangswandler sind lediglich angedeutet und liegen an ihren jeweiligen Sammelschienen 4, 5; 8, 9; 18, 19 bzw. 25, 33, welche wiederum über Bonddrähte 11, 12; 20, 21 bzw. 27, 36 mit äußeren Anschlußelementen kontaktiert sind.

Wie bereits erwähnt wurde, zeichnet sich dieses Filter durch eine verhältnismäßig geringe Filterdämpfung aus; besitzt jedoch den Nachteil, daß Signale des Eingangswandlers EWII in den Ausgangswandler AWI für das ZF-Videosignal übersprechen.

Während der in Figur 1 dargestellte Eingangswandler EWII für das Ton- und Bildträgersignal mehrere Hauptkeulen und zahlreiche kleine Überlappungen seiner Elektrodenfinger 6, 7 unterschiedlicher Polarität besitzt, zeichnet sich der ausschließlich für die Toninformation konzipierte Eingangswandler EWIII nach Figur 3 durch eine breite Hauptkeule, d.h. durch Elektrodenfinger 21, 22 mit großem Überlappungsbereich und durch nur wenige Bereiche mit ausschließlich geringen Elektrodenfingerüberlappungen aus.

Dieses Filter besitzt gleichfalls ein Substrat aus piezoelektrischem Werkstoff, eine bei 30 an Massepotential liegende Abschirmelektrode 29 und einen üblichen Ausgangswandler AWIII mit Elektrodenfingern 30, 31, die über Sammelschienen 32 bzw. 35 und entsprechende Bonddrähte 34, 37 mit äußeren, nicht dargestellten Anschlüssen kontaktiert sind.

Die Elektrodenfinger 21, 22 unterschiedlicher Polarität des Eingangswandlers EWIII sind über Sammelschienen 23, 24 und Bonddrähte 26, 28 mit gleichfalls nicht gezeigten Eingangselementen vorgeschalteter Schaltkreise oder dergleichen kontaktiert.

Die Durchlaßcharakteristik d dieses Filters, die nur im Tonträgerbereich eine geringe Durchlaßdämpfung aufweist ist aus Figur 4 ersichtlich.

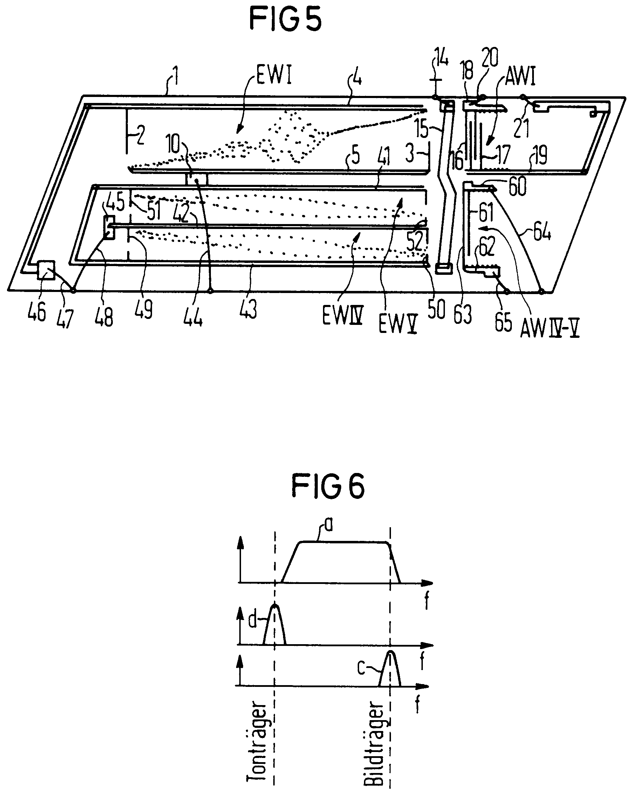

Das in Figur 5, 6 dargestellte Ausführungsbeispiel nach der Erfindung ist, soweit dies den Eingangs- und Ausgangswandler EWI bzw. AWI für das Videosignal und den Multistripkoppler 15 betrifft, gleich den entsprechenden Elementen nach Figur 1, weshalb hierfür gleiche Bezugszeichen gewählt wurden und sich die nochmalige Erläuterung dieser Elemente erübrigt.

Der beim Filter nach Figur 1 zum Eingangswandler EWI für das ZF-Videosignal über das Kontaktelement 10 parallelgeschaltete gemeinsame Eingangswandler EWII für das Ton- und Bildträgersignal ist bei der erfindungsgemäßen Ausführung in zueinander parallelgeschaltete Eingangswandler EWIV und EWV aufgetrennt. Als Ausgangswandler AWIV-V ist dabei ein gemeinsamer vorgesehen, dessen Apertur die Aperturen der Eingangswandler EWIV und EWV umfaßt.

Die Wandlerstrukturen beider Eingangswandler EWIV und EWV entsprechen in etwa jener des Eingangswandlers gemäß Figur 3; d.h., daß auch hier bevorzugt nur eine durch die entsprechende Überlappung der Elektrodenfinger unterschiedlicher Polarität geschaffene, breite Hauptkeule vorgesehen ist, die in den Randbereichen der Wandlerstrukturen durch wenige kleine Überlappungen der Elektrodenfinger begrenzt sind.

Die mit 49, 50; 51, 52 bezeichneten Elektrodenfinger der Eingangswandler EWIV und EWV sind teils mit einer gemeinsamen Sammelschiene 42 bzw. Sammelschienen 41, 43 kontaktiert, die wiederum über Kontaktflächen 45 und Bonddrähte 44, 48 mit in der Zeichnung nicht dargestellten äußeren Anschlußelementen verbunden sind. Gleiches gilt für die Sammelschiene 4 des Eingangswandlers EWI der über eine Kontaktfläche 46 und einen Bonddraht 47 an Anschlußelemente vorgeschalteter Schaltkreise oder dergleichen anschließbar ist.

Der gemeinsame Ausgangswandler AWIV-V besitzt schließlich Elektrodenfinger 61, 63, die über ihre jeweiligen Sammelschienen 60, 62 und hiermit kontaktierten Bonddrähten 64 bzw. 65 an äußeren Anschlußelementen liegen.

Die Übertragungscharakteristik für die einzelnen Eingangswandler und ihre nachgeschalteten Ausgangswandler ist schließlich Figur 6 zu entnehmen, wobei die Kurven a, b und c den Signalverlauf des ZF-Videosignals, des Tonträgersignals bzw. des Bildträgersignals über der Frequenz wiedergeben.

**Patentansprüche**

1. Fernseh-ZF-Filter für Quasi-/Paralleltonanwendungen, mit einem Eingangswandler für das ZF-Videosignal und einem hierzu parallelgeschalteten Eingangswandler für das Ton- und Bildträgersignal, denen jeweils Ausgangswandler nachgeordnet sind, **dadurch gekennzeichnet,** daß der Eingangswandler für das Ton- und Bildträgersignal in zueinander parallelgeschaltete Eingangswandler (EWIV, EWV) für das Ton- bzw. Bildträgersignal (b, c) mit einem gemeinsamen Ausgangswandler (AWIV-V) aufgetrennt ist, dessen Apertur die Aperturen der Eingangswandler für das Ton- und Bildträgersignal umfaßt.

## FIG 1

## FIG 2

## FIG 3

## FIG 4

# FIG 5

# FIG 6

Europäisches Patentamt

Nummer der Anmeldung

EP 90 12 3359

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A-2 146 823 (PHILIPS)<br>* Seite 2, Zeile 12 - Zeile 26 *<br>* Seite 3, Zeile 23 - Seite 4, Zeile 15 *<br>* Seite 4, Zeile 31 - Seite 5, Zeile 7; Abbildung 1 *<br>--- | 1 | H03H9/70<br>H03H9/145 |
| A | EP-A-367 864 (SIEMENS)<br>* Zusammenfassung *<br>* Spalte 3, Zeile 1 - Zeile 48; Abbildung 1 *<br>--- | 1 | |
| A | US-A-4 062 044 (HANMA ET AL)<br>* Spalte 7, Zeile 34 - Zeile 57; Abbildungen 3,6 *<br>----- | 1 | |

|  | RECHERCHIERTE SACHGEBIETE (Int. Cl.5) |
|---|---|
|  | H03H |

Der vorliegende Recherchenbericht wurde für alle Patentansprüche erstellt

| Recherchenort | Abschlußdatum der Recherche | Prüfer |
|---|---|---|
| DEN HAAG | 02 AUGUST 1991 | WRIGHT J.P. |